# FASCICULE DE BREVET EUROPEEN

(11) **EP 1 937 048 B1**
(45) Date de publication et mention de la délivrance du brevet: **22.07.2009**
(21) Numéro de dépôt: 07121320.1
(22) Date de dépôt: 22.11.2007
(51) Int. Cl.: H05K 7/20, H05K 7/14

(54) **Dispositif à composants électroniques intégrés muni d'une cloison de séparation de zones ventilées**
Vorrichtung mit integrierten elektronischen Bauteilen, die mit einer Trennwand der belüfteten Zonen ausgestattet ist
Device with integrated electronic components equipped with a partition for separating ventilated areas

(30) Priorité: 18.12.2006 FR 0611024
(43) Date de publication de la demande: 25.06.2008
(73) Titulaire: SAGEM Défense Sécurité, 75015 Paris (FR)
(72) Inventeur: Besold, Jean-Eric, 75015, PARIS (FR); Merlet, Etienne, 75015, PARIS (FR)
(74) Mandataire: Cabinet Plasseraud

(56) Documents cités:
- EP-A1- 0 578 520
- WO-A-20/07047388
- FR-A1- 2 864 423
- JP-A- 62 117 399

## Description

L'invention a trait aux dispositifs à composants électroniques intégrés.
Elle concerne plus particulièrement un dispositif à composants électroniques intégrés comportant une carte formant support pour lesdits circuits, ainsi qu'un capot monté sur cette carte pour recouvrir les circuits.

On trouve de tels dispositifs dans de nombreux domaines, et plus particulièrement dans l'aviation, domaine dans lequel les problèmes liés à ce type de dispositif se sont posés aux inventeurs.

En effet, ces dispositifs sont couramment employés pour la commande de diverses parties fonctionnelles des avions ou des hélicoptères, et notamment la commande de pilotage automatique.

Dans ce domaine particulier, il est essentiel d'assurer une sécurité de fonctionnement permanente des composants électroniques du dispositif, afin de garantir sécurité et précision du pilotage automatique.

Certains dispositifs électroniques destinés à la commande de pilotage automatique comprennent, implantés sur la carte support, deux circuits électroniques de commande distincts susceptibles de prendre le relais l'un de l'autre en cas de panne.

Compte tenu des conditions thermiques extrêmes auxquelles sont soumis les composants, il est nécessaire d'assurer une ventilation permanente du dispositif. Généralement, cette ventilation est assurée par un courant d'air de refroidissement qui circule parallèlement à la surface de la carte support.

Un inconvénient de cette disposition est que, lorsqu'un composant de l'un des deux circuits explose, le courant d'air de refroidissement risque de charrier les débris du composant en question et de les disséminer sur le circuit parallèle. Compte tenu de la sensibilité de certains composants de ce dernier, les débris risquent d'endommager le circuit parallèle, sans compter que, si ces débris sont conducteurs, ils peuvent créer au sein du circuit parallèle des courts-circuits.

Afin de résoudre ce problème, il a été proposé, dans le document FR 2 864 423, un dispositif à composants électroniques intégrés muni d'une cloison de séparation grillagée. Plus précisément, le document FR 2 864 423 propose un dispositif à composants électroniques intégrés, qui comporte une carte formant support pour lesdits composants, ainsi qu'un capot monté sur ladite carte pour recouvrir lesdits composants, ainsi qu'une cloison grillagée qui s'étend du capot à la carte sensiblement perpendiculairement à celle-ci, ladite cloison séparant deux zones distinctes de la carte dans lesquelles sont disposés des composants électroniques.

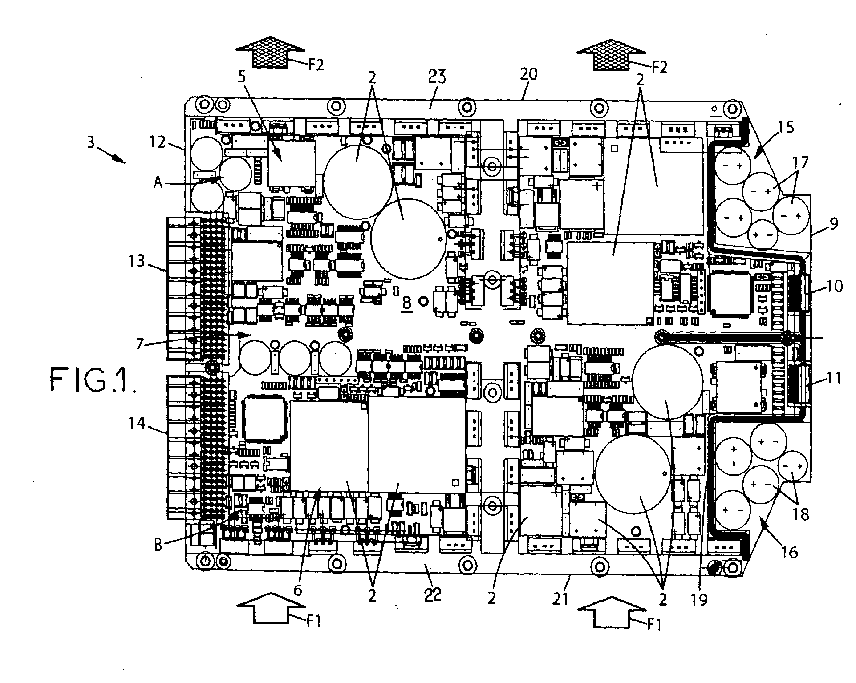

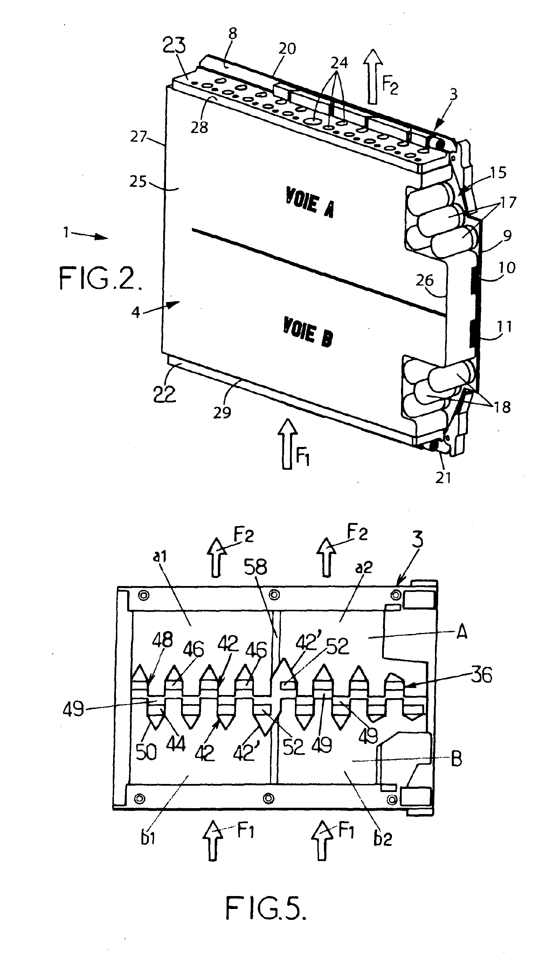

Plus précisément, la figure 1 représente une vue en plan d'une carte formant support pour lesdits circuits électroniques, et notamment décrite dans le document FR 2 864 423, et la figure 2 est une vue schématique en perspective du dispositif de protection de zones décrit dans ce même document FR 2 864 423.

Sur la figure 2 est ainsi illustré un dispositif 1 à composants électroniques 2 intégrés, qui comporte une carte 3, représentée en plan sur la figure 1, formant un support sur lequel sont implantés les composants 2, ainsi qu'un capot 4 destiné à être monté sur la carte 3 pour recouvrir les composants 2 et ainsi les protéger des conséquences d'une éventuelle destruction de certains d'entre eux.

Comme cela est visible sur la figure 1, les composants 2 sont regroupés dans deux zones 5, 6 distinctes adjacentes qui constituent deux circuits électroniques de commande distincts. Il s'agit en pratique de circuits de commande d'un système de pilotage automatique d'un avion ou d'un hélicoptère. Dans la suite de la description, ces circuits sont respectivement dénommés VOIE A et VOIE B.

Comme cela apparaît sur la figure 1, les voies A et B sont légèrement écartées l'une de l'autre, un interstice 7 étant ménagé entre elles sur la carte 3. On n'entrera pas dans les détails de réalisation des circuits 5, 6. Indiquons toutefois que la carte 3 comporte une plaque 8 sensiblement rectangulaire réalisée dans un matériau isolant, qui forme le support sur lequel sont implantés les composants 2.

Précisons également que la carte 3 présente un bord avant 9 sur lequel sont montés un connecteur primaire 10 pour le branchement d'un câble de test et mise au point de la voie A et un connecteur secondaire 11 adjacent au connecteur primaire 10, pour le branchement d'un câble de test et mise au point de la voie B. La carte 3 présente également un bord arrière 12, opposé au bord avant 9, sur lequel sont montés, du côté de la voie A, un connecteur primaire de fond de panier 13 pour le branchement d'un bus d'alimentation et de liaison de la voie A au système commandé (en l'occurrence le pilote automatique) et, du côté de la voie B, un connecteur secondaire de fond de panier 14 pour le branchement d'un bus d'alimentation et de liaison de la voie B au système commandé.

Comme cela est visible sur la figure 1, la carte 3 présente, du côté de son bord avant 9, deux zones auxiliaires 15, 16 dans lesquelles sont implantés des condensateurs de filtrage 17, 18 associés aux voies A et B, respectivement.

La carte 3 peut en outre comporter une cloison 19 qui sépare les zones auxiliaires 15, 16 des voies respectives A et B afin d'isoler les condensateurs 17, 18 des autres composants 2 de la voie correspondante. Suivant un mode préféré de réalisation, cette cloison est constituée par un bord avant du capot 4.

En outre, comme cela est visible sur la figure 2, la carte 3 présente, le long de deux bords latéraux 20, 21 joignant les bords avant 9 et arrière 12, deux parois 22, 23, à savoir une paroi amont 22 bordant la voie B et une paroi aval 23 bordant, à l'opposé, la voie A, parois dans lesquelles sont pratiquées des ouvertures 24 pour permettre le passage d'un courant d'air de refroidissement qui, s'engouffrant par la paroi amont 22 (flèches F1), est évacué par la paroi aval 23 (flèches F2) après avoir subi un transfert de chaleur avec les composants 2 des voies A et B. En l'occurrence, les cloisons latérales 22 et 23 sont formées par des radiateurs fixés sur la carte 3, qui permettent le montage sur celle-ci de composants électroniques à forte dissipation calorique. Dans l'hypothèse où de tels radiateurs s'avéreraient inutiles, les cloisons latérales 22, 23 pourraient être formés par des bords latéraux du capot 4.

Le capot 4 comporte quant à lui une paroi de fond 25 sensiblement plane, de forme sensiblement rectangulaire, destinée à recouvrir conjointement les voies A et B, et qui présente un bord avant 26 et un bord arrière 27 destinés à venir se placer au droit des bords avant 9 et arrière 12 de la carte 3, respectivement, reliés par deux bords latéraux 28, 29 parallèles destinés à venir se placer entre et contre les parois amont 22 et aval 23 de la carte 3.

Toutefois, le Demandeur a pu constater que le dispositif décrit dans le document FR 2 864 423 ne permet pas une ventilation et un refroidissement suffisants et équivalents des voies A et B de la carte 3.

En effet, avant de refroidir la voie A, le courant de ventilation a déjà traversé la voie B. L'air arrivant au niveau de la voie A s'est donc déjà réchauffé et ne peut pas refroidir de manière équivalente la voie A.

L'invention vise notamment à résoudre ce problème en réalisant un dispositif permettant un refroidissement identique entre la voie A et la voie B de la carte 3.

Il est connu selon l'art antérieur de prévoir dans ce cas un double circuit de ventilation, à savoir un circuit de ventilation pour la voie A et un circuit de ventilation pour la voie B. Pour ce faire, afin de permettre la formation de deux ventilations identiques pour les deux voies A et B, il est nécessaire de prévoir une voie thermique traversant la voie A et une voie thermique traversant la voie B. Cette solution impose une disposition verticale des voies A et B : par exemple, la voie A en zone avant, et la voie B en zone arrière. Mais alors, si on maintient l'idée de cartes enfichables en fond de panier, pour conserver l'accès de la voie A aux connecteurs arrières de fond de panier, et éventuellement l'accès de la voie B aux connecteurs de tests de la face avant, il devient nécessaire de définir aux travers de chacune des voies, une zone de transite des alimentations et signaux de la voie opposée.

De plus, cette solution n'est pas satisfaisante en termes de coût et d'encombrement.

L'invention vise donc à résoudre les inconvénients précités en proposant un dispositif du type précité, qui permet une ventilation identique ou équivalente de deux voies d'une carte enfichable en formant une ségrégation thermique des deux voies, tout en évitant tout couplage thermique entre les deux voies.

Un des objets de l'invention a également pour but d'éviter la contagion des pannes de l'un à l'autre des circuits et de garantir une sécurité de fonctionnement accrue des composants électroniques.

Un des objets de l'invention a également pour but soit de former une ségrégation anti-feu, soit de former un blindage d'interférences électromagnétiques entre deux voies identiques d'une carte enfichable.

Selon un premier de ses aspects, la présente invention porte sur un dispositif à composants électroniques intégrés, qui comporte une carte formant support pour les composants, un capot monté sur la carte pour recouvrir les composants, ainsi qu'une cloison séparatrice qui s'étend du capot à la carte sensiblement perpendiculairement à celle-ci, la cloison séparant deux zones distinctes de la carte dans lesquelles sont disposés des composants électroniques, du gaz de refroidissement étant apte à être injecté dans une des deux zones distinctes de la carte dite « zone amont », et apte à être évacué dans l'autre des deux zones distinctes de la carte, dite « zone aval», caractérisé en ce qu'il comprend un surcapot recouvrant le capot et définissant un espace interne entre le capot et le surcapot dans lequel sont prévus des moyens de répartition de gaz de refroidissement délimitant deux espaces secondaires distincts dans l'espace interne, un espace secondaire amont dans lequel du gaz de refroidissement est apte à être injecté et un espace secondaire aval dans lequel du gaz de refroidissement est apte à être évacué de manière telle que du gaz de refroidissement injecté dans la zone amont de la carte soit dirigé vers l'espace secondaire aval de l'espace interne et que du gaz de refroidissement injecté dans l'espace secondaire amont de l'espace interne soit dirigé vers la zone aval de la carte.

De manière à permettre l'échange de gaz de refroidissement entre l'espace interne et les zones amont/aval de la carte, les moyens de répartition du gaz de refroidissement comprennent au moins une paire de déflecteurs associée à au moins une paire d'orifices prévus dans le capot de part et d'autre de la cloison séparatrice, au moins un déflecteur débouchant dans l'espace secondaire aval et au moins un déflecteur débouchant dans l'espace secondaire amont.

Afin de refroidir de manière identique deux circuits identiques prévus de part et d'autre de la cloison séparatrice de la carte, les déflecteurs sont répartis de manière symétrique par rapport à la cloison séparatrice.

Afin de former un écoulement laminaire et sans perte de charges ni tourbillon et zone morte lors du passage du gaz de refroidissement d'un espace secondaire vers une zone de la carte, et inversement, le déflecteur comprend une zone biseautée à épaisseur croissante avec un bord sensiblement confondu avec le surcapot et un autre bord sensiblement confondu avec le capot.

Toujours afin de former un écoulement du gaz de refroidissement sans perte de charges ni tourbillon et zone morte, le bord sensiblement confondu avec le capot de la zone biseautée du déflecteur forme un bord d'attaque pour un déflecteur situé dans l'espace secondaire amont et un bord de fuite pour un déflecteur situé dans l'espace secondaire aval.

De manière similaire, le bord sensiblement confondu avec le surcapot de la zone biseautée du déflecteur forme un bord de fuite pour un déflecteur situé dans l'espace secondaire amont et un bord d'attaque pour un déflecteur situé dans l'espace secondaire aval.

Selon une forme de réalisation avantageuse d'un déflecteur permettant l'écoulement sans perte de charges du gaz de refroidissement, chaque déflecteur comprend une zone centrale, sensiblement quadrangulaire, et une zone triangulaire formant une extrémité en pointe, la hauteur de chacune des zones centrale et triangulaire étant égale à la distance entre le capot et le surcapot.

Afin de former une ségrégation anti-feu entre les deux circuits électroniques de la carte, chaque déflecteur est réalisé en un matériau ininflammable, par exemple du type polymère.

Afin de former un blindage électromagnétique entre les deux circuits électroniques de la carte, chaque déflecteur est réalisé en un matériau électriquement conducteur, par exemple du type métallique, ou polymère chargé et/ou revêtu.

Selon un second de ses aspects, la présente invention porte sur un procédé de refroidissement de deux zones distinctes d'un dispositif à composants électroniques intégrés qui comporte une carte formant support pour les composants, un capot monté sur la carte pour recouvrir les composants, ainsi qu'une cloison séparatrice qui s'étend du capot à la carte sensiblement perpendiculairement à celle-ci, la cloison séparant les deux zones distinctes de la carte dans lesquelles sont disposés les composants électroniques, du gaz de refroidissement étant apte à être injecté dans une des deux zones distinctes de la carte dite « zone amont », et apte à être évacué dans l'autre des deux zones distinctes de la carte, dite « zone aval» (A), caractérisé en ce qu'il comprend une étape de passage de gaz de refroidissement par des moyens de répartition de gaz prévus dans un espace interne entre le capot et un surcapot délimitant deux espaces secondaires distincts dans l'espace interne, un espace secondaire amont dans lequel du gaz de refroidissement est injecté et un espace secondaire aval dans lequel du gaz de refroidissement est évacué de manière telle que du gaz de refroidissement injecté dans la zone amont de la carte soit dirigé vers l'espace secondaire aval de l'espace interne et que du gaz de refroidissement injecté dans l'espace secondaire amont de l'espace interne soit dirigé vers la zone aval de la carte.

La présente invention est maintenant décrite à l'aide d'un exemple uniquement illustratif et nullement limitatif de la portée de l'invention. D'autres objets et avantages de l'invention apparaîtront à la lumière de la description faite ci-après en référence aux dessins annexés dans lesquels:
- la figure 1 est une vue en plan d'une carte électronique sur laquelle sont implantés des composants électroniques de deux circuits parallèles de commande;
- la figure 2 est une vue schématique en perspective d'un dispositif selon l'art antérieur illustrant la carte de la figure 1, qui comprend une carte sur laquelle est monté un capot recouvrant conjointement les deux circuits de commande, le capot portant deux inscriptions, VOIE A et VOIE B, correspondant chacune à l'un des circuits pour permettre leur identification par un technicien de maintenance;
- la figure 3 est une vue éclatée en perspective du dispositif à composants intégrés selon l'invention ;

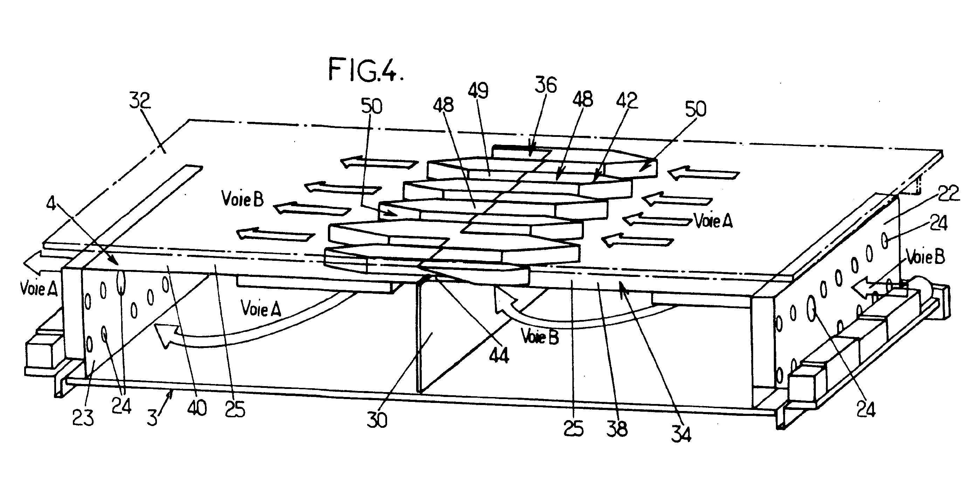

- la figure 4 est une vue latérale en perspective du dispositif selon l'invention, le surcapot étant représenté en transparence ;
- la figure 5 est une vue supérieure des moyens de répartition d'air fixés sur le capot ; le capot et le surcapot n'étant pas représentés par mesure de clarté.

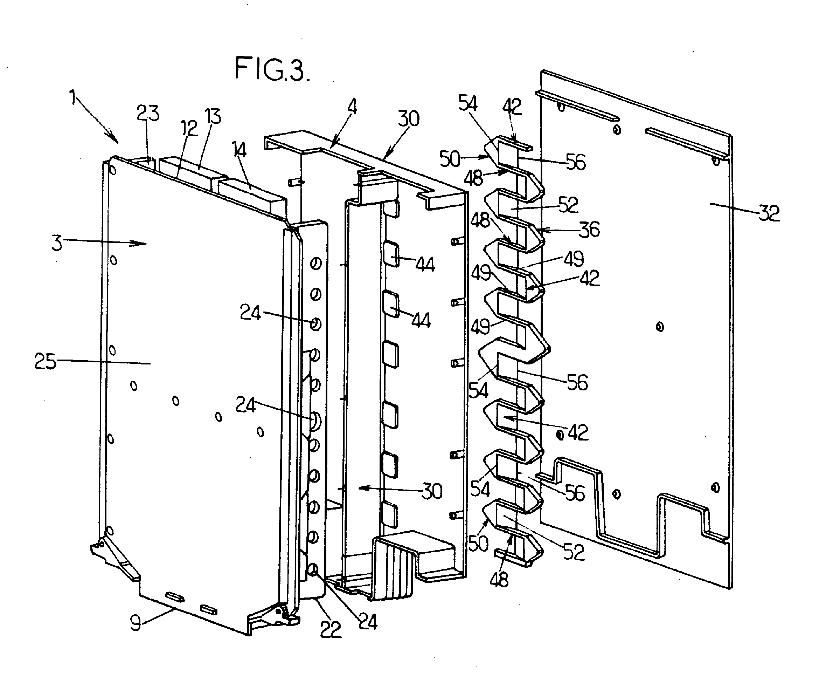

Sur la figure 3 est représentée, selon une vue éclatée en perspective, une carte 3 telle que décrite dans la figure 1, recouverte par un capot 4 avec au moins une cloison 30 à paroi pleine, c'est-à-dire sans ouverture et non grillagée, apte à séparer physiquement les voies A et B et à empêcher le passage d'air de l'une des deux voies A, B vers l'autre des deux voies A, B.

La présente invention porte donc sur un dispositif 1 à composants électroniques intégrés 2, qui comporte une carte 3 formant support pour les composants 2, un capot 4 monté sur la carte 3 pour recouvrir les composants 2, ainsi qu'une cloison 30 qui s'étend du capot 4 à la carte 3 sensiblement perpendiculairement à celle-ci, ladite cloison 30 séparant deux zones distinctes A, B de la carte 3 dans lesquelles sont disposés des composants électroniques 2, de l'air étant apte à être injecté dans une des deux zones distinctes A, B de la carte dite « zone amont B», et apte à être évacué dans l'autre des deux zones distinctes A, B de la carte, dite « zone aval A».

Le dispositif 1 comprend également un surcapot 32 recouvrant le capot 4 et définissant un espace interne 34 entre le capot 4 et le surcapot 32 dans lequel sont prévus des moyens 36 de répartition/distribution/orientation de gaz de refroidissement (préférentiellement de l'air) délimitant deux espaces secondaires distincts 38, 40 dans l'espace interne 34, un espace secondaire amont 38 dans lequel de l'air est apte à être injecté et un espace secondaire aval 40 dans lequel de l'air est apte à être évacué de manière que de l'air injecté dans la zone amont B de la carte 3 soit dirigé vers l'espace secondaire aval 40 de l'espace interne 34 et que de l'air injecté dans l'espace secondaire amont 38 de l'espace interne 34 soit dirigé vers la zone aval A de la carte 3.

Bien que dans la description l'invention soit décrite pour un refroidissement des circuits électroniques à l'aide d'air, il est bien entendu que le principe de l'invention reste identique pour tout gaz de refroidissement.

Les moyens 36 de répartition d'air peuvent être soit prévus de manière indépendante du capot 4, et y sont fixés par tout moyen de fixation, par exemple par vissage et/ou collage, soit prévus directement intégrés dans le capot 4, les moyens de répartition d'air 36 et le capot 4 formant alors un ensemble monobloc.

Les moyens 36 de répartition d'air peuvent aussi être soit prévus de manière indépendante du capot 4 et surcapot 32, et y sont fixés par tout moyen de fixation, par exemple par vissage et/ou collage de l'ensemble des trois pièces, soit prévus directement intégrés dans le capot 4 et le surcapot 32, les moyens de répartition d'air 36, le capot 4, et le surcapot 32 formant alors un ensemble monobloc réalisé simultanément, par exemple par stéréolithographie.

Les moyens 36 de répartition d'air comprennent au moins une paire de déflecteurs 42 associée à au moins une paire d'orifices 44, 46 prévus dans le capot 4, et plus précisément dans la paroi de fond 25 du capot 4, de part et d'autre de la cloison séparatrice 30. Ainsi, au moins un déflecteur 42 débouche dans l'espace secondaire amont 38 et au moins un déflecteur 42 débouche dans l'espace secondaire aval 40.

Il est ainsi formé un premier ensemble d'orifices en amont 44, c'est-à-dire un ensemble d'orifices situés dans la zone amont B de la carte 2, et un second ensemble d'orifices en aval 46, c'est-à-dire un ensemble d'orifices situés dans la zone aval A de la carte 2. Ainsi, à chaque orifice 44, 46 formé soit dans la paroi de fond 25 recouvrant la zone amont B de la carte 2, soit dans la paroi de fond 25 recouvrant la zone aval A de la carte 2, il est associé un déflecteur 42 apte à dévier de l'air injecté dans une des zones A, B de la carte 3 vers un espace secondaire 38, 40 de l'espace interne 34, et apte à dévier de l'air injecté dans un des espaces secondaires 38, 40 de l'espace interne 34 vers une des zones A, B de la carte 3.

Chaque déflecteur 42 comprend une zone centrale 48, sensiblement quadrangulaire, par exemple sous la forme d'un carré ou d'un rectangle, et une zone triangulaire 50 formant une extrémité en pointe, et accolée à l'un des bords de la zone centrale 48, la hauteur ou épaisseur de chacune des zones centrale 48 et triangulaire 50 étant égale à la distance entre le capot 4 et le surcapot 32.

La zone centrale 48 présente une zone biseautée 52 à épaisseur croissante de manière telle qu'un bord 54 de la zone biseautée 52 soit sensiblement confondu avec le capot 4 et qu'un autre bord 56 de la zone biseautée 52 soit sensiblement confondu avec le surcapot 32, une fois celui-ci fixé au capot 4. La zone biseautée 52 forme une surface planaire permettant un écoulement laminaire de l'air.

Autrement dit, une fois les moyens 36 de répartition d'air fixés sur le capot 4 ou quand ils sont directement formés avec le capot 4 et/ou le surcapot 32, chaque zone biseautée 52 présente un bord proximal 56, situé près de la cloison séparatrice 30, qui est le bord sensiblement confondu avec le surcapot 32 et un bord distal 54, éloigné de la cloison séparatrice 30, qui est sensiblement confondu avec le capot 4.

La zone centrale 48 présente deux branches 49 parallèles entre elles et entre lesquelles est formée la zone biseautée 52, les bords proximal et distal 54, 56 de la zone biseautée 52 étant alors prévus perpendiculaires aux branches 49.

Les orifices 44, 46 prévus dans le capot 4 sont formés de manière alternée de part et d'autre de la cloison séparatrice 30 ainsi que le long de la zone d'appui de la cloison 30 sur la paroi de fond 25 du capot 4.

Les orifices 44, 46 sont avantageusement prévus de forme quadrangulaire avec un bord proximal de l'orifice 44, 46 en aplomb du bord proximal 56 de la zone biseautée 52 du déflecteur 42 et un autre bord distal de l'orifice 44, 46 sensiblement confondu avec le bord distal 54 de la zone biseautée 52 du déflecteur 42.

Lors de l'injection simultanée d'air de refroidissement dans la zone amont B et dans l'espace secondaire amont 38, le bord 56 sensiblement confondu avec le capot 3, ou bord distal 54, de la zone biseautée 52 du déflecteur 42 forme un bord d'attaque pour un déflecteur 42 situé dans l'espace secondaire amont 38 et un bord de fuite pour un déflecteur 42 situé dans l'espace secondaire aval 40. De manière similaire et symétrique, le bord 54 sensiblement confondu avec le surcapot 32 de la zone biseautée 52 du déflecteur 42 forme un bord de fuite pour un déflecteur 42 situé dans l'espace secondaire amont 38 et un bord d'attaque pour un déflecteur 42 situé dans l'espace secondaire aval 40.

Les déflecteurs 42 prévus dans l'espace interne 32 sont formés de manière telle qu'au moins un déflecteur 42 situé dans l'espace secondaire amont 38 est en contact latéral avec au moins un déflecteur 42 situé dans l'espace secondaire aval 40. Ainsi, les moyens de répartition d'air 36 se composent préférentiellement d'une pluralité de déflecteurs 42 avec une alternance de déflecteurs de part et d'autre de la cloison 30, chaque déflecteur 42 présentant alors au moins une branche 49 en commun avec un déflecteur 42 immédiatement voisin.

De manière supplémentaire, et comme cela est plus particulièrement visible sur la figure 5, chaque zone centrale 48 comprend une zone secondaire 49, permettant de décaler le zone biseautée soit vers la paroi amont 22, soit vers la paroi aval 23, de hauteur égale à la distance entre le capot 4 et le surcapot 32, la zone biseautée 52 étant prévue entre la zone en pointe 50 et cette zone 49. La largeur de la zone secondaire 49 est paramétrée de manière telle que l'épaisseur de la cloison 30 est sensiblement égale ou inférieure à la somme de la largeur de la zone secondaire 49 d'un déflecteur amont 42 et de la largeur de la zone secondaire 49 d'un déflecteur aval 42. Ainsi, il est obtenu une évacuation ou une entrée d'air de refroidissement dans les déflecteurs 42 au niveau de chaque face de la cloison séparatrice 30.

A titre d'exemple, la nappe d'air circulant dans l'espace interne 32 est de quelques millimètres.

De plus, toujours afin de réduire autant que possible la perte de charge du flux d'air circulant dans l'espace secondaire amont 38 et la zone amont B, il est prévu que la section de passage cumulée correspondant à l'ensemble des bords distals de chaque orifice 44, 46 formés dans la paroi de fond du capot 4 soit plus grande que la section de passage entre le capot 4 et le surcapot 32.

Ainsi, selon l'invention, il est obtenu un débit d'air constant entre l'air passant dans l'espace secondaire amont 38 et dans la zone amont B, l'homme du métier étant apte à paramétrer les dimensions des ouvertures 24 dans la paroi amont 22 pour que la même quantité d'air circule dans la zone amont B et dans l'espace secondaire amont 38.

De même, afin d'éviter toute perte de charge, tourbillon d'air, ou zone morte sans ventilation, lors du passage de l'air de refroidissement de l'espace secondaire amont 38 vers la zone aval A et de la zone amont B vers l'espace secondaire aval 40, il est prévu de ne former aucun angle droit et de ne prévoir que des surfaces lisses permettant la formation d'un courant sans turbulence, ni tourbillon d'air, ou zone morte sans ventilation, susceptible de créer une perte de charge ou des zones mal refroidies sur la carte, lors de la circulation de l'air de refroidissement à travers la carte 3.

Les extrémités en pointe 50 des déflecteurs 42 sont formées de manière symétrique par rapport à la zone centrale 48 de manière à partager en deux sans turbulence le flux d'air arrivant sur cette leur pointe 50.

Selon un mode de réalisation préférentiel, il est prévu une symétrie entre les déflecteurs 42 situés dans l'espace secondaire amont 38 et les déflecteurs 42 situés dans l'espace secondaire aval 40 (et par conséquent une symétrie des orifices 44, 46 prévus de part et d'autre de la cloison séparatrice 30).

Toutefois, il est également possible de prévoir une alimentation en air de refroidissement différente entre les deux zones distinctes A, B de la carte 3, par exemple en prévoyant plus de déflecteurs dans l'un des deux espaces secondaires 38, 40 de l'espace interne 32 entre le capot 4 et le surcapot 32 et/ou en injectant plus d'air dans la zone amont B par rapport à l'espace secondaire amont 38, et inversement ou par exemple en prévoyant des orifices 44 plus grands ou plus petits.

Selon l'invention, on obtient ainsi une distribution d'air entre deux zones distinctes A, B de la carte 3, l'air n'ayant pas été préalablement réchauffé par son passage à travers une des deux zones A, B avant de refroidir l'autre des deux zones A, B de la carte 3.

Selon une première forme de réalisation des moyens de répartition d'air 32, les déflecteurs 42, ainsi que le capot 4, et éventuellement le surcapot 32, sont réalisés en un matériau ininflammable ou auto-extinguible, par exemple du type polymère, soit moulable, soit injectable, soit réalisé par stéréolithographie. Ainsi, en plus d'une ségrégation thermique entre les deux zones distinctes A, B de la carte 3, il est également obtenu une ségrégation anti feu entre les deux zones distinctes A, B.

Selon une seconde forme de réalisation des moyens de répartition d'air 32, les déflecteurs 42, ainsi que le capot 4, et éventuellement le surcapot 32, sont réalisés en un matériau électriquement conducteur, par exemple du type métallique (tel que de l'aluminium), ou polymère chargé et/ou revêtu. Ainsi, en plus d'une ségrégation thermique entre les deux zones distinctes A, B de la carte 3, il est également obtenu un blindage d'interférence électromagnétique ou EMI (« Electro-Magnetic Interference ») entre les deux zones distinctes A, B de la carte 3, et éventuellement vis-à-vis de l'extérieur (en émission / réception).

Par ailleurs, selon un mode de réalisation particulier illustré sur la figure 5, du fait de la présence d'un radiateur central 58, perpendiculaire à la cloison séparatrice 30, formant également une cloison séparant chaque zones distinctes A, B de la carte 3 en deux sous-zones (a₁, a₂) et (b₁, b₂), il est nécessaire de prévoir, pour les déflecteurs 42' fixés partiellement en aplomb de ce radiateur central 58, une zone biseautée 52 décalée latéralement de manière à ce que l'ouverture formée par la zone biseautée 52 ne soit pas partiellement bouchée par la présence de ce radiateur central 58.

De manière résumée, grâce à l'invention, on obtient un refroidissement séparé des deux zones distinctes A, B de la carte 3 avec, pour le refroidissement de la zone amont B, l'injection de l'air de refroidissement directement dans la zone amont B par les ouvertures 24 dans la paroi amont 22, puis le passage de cet air partiellement réchauffé dans l'espace secondaire aval 40 après son transfert par les déflecteurs 42 situés dans l'espace secondaire amont 38.

Pour le refroidissement de la zone aval A, l'air de refroidissement est tout d'abord injecté dans l'espace secondaire amont 38, où il ne se réchauffe pas puisqu'il n'est pas en contact avec des composants électroniques 2, cet air passant ensuite dans la zone aval A où il est partiellement réchauffé avant d'être évacué par les ouvertures 24 prévues dans la paroi aval 23, après son transfert par les déflecteurs 42 situés dans l'espace secondaire aval 40. L'air injecté dans l'espace secondaire amont 38 a un écoulement laminaire du fait des extrémités en pointe 50 des déflecteurs 42 situés dans cet espace secondaire amont 42 permettant une division égalitaire en deux du courant frappant ces pointes 50 et son passage sans turbulence dans la zone biseautée 52 d'un déflecteur 42 situé dans l'espace secondaire aval 40 pour son évacuation vers la zone aval A. De même, le courant quittant la zone biseautée 52 d'un déflecteur 42 situé dans l'espace secondaire amont 38, qui a donc été préalablement directement injecté dans la zone amont B, a un écoulement laminaire, du fait des extrémités en pointe 50 symétriques des déflecteurs 42 situés dans l'espace secondaire aval 40.

## Revendications

1. Dispositif (1) à composants électroniques intégrés (2), qui comporte une carte (3) formant support pour lesdits composants (2), un capot (4) monté sur ladite carte (3) pour recouvrir lesdits composants (2), ainsi qu'une cloison (30) séparatrice qui s'étend du capot (4) à la carte (3) sensiblement perpendiculairement à celle-ci, ladite cloison (30) séparant deux zones distinctes (A, B) de la carte (3) dans lesquelles sont disposés des composants électroniques (2), du gaz de refroidissement étant apte à être injecté dans une des deux zones distinctes (A, B) de la carte dite « zone amont » (B), et apte à être évacué dans l'autre des deux zones distinctes (A, B) de la carte, dite « zone naval» (A), **caractérisé en ce qu'**il comprend un surcapot (32) recouvrant le capot (4) et définissant un espace interne entre le capot (4) et le surcapot (32) dans lequel sont prévus des moyens de répartition de gaz de refroidissement (36) délimitant deux espaces secondaires (38, 40) distincts dans l'espace interne (34), un espace secondaire amont (38) dans lequel du gaz de refroidissement est apte à être injecté et un espace secondaire aval (40) dans lequel du gaz de refroidissement est apte à être évacué de manière telle que du gaz de refroidissement injecté dans la zone amont (B) de la carte (3) soit dirigé vers l'espace secondaire aval (40) de l'espace interne (34) et que du gaz de refroidissement injecté dans l'espace secondaire amont (38) de l'espace interne (34) soit dirigé vers la zone aval (A) de la carte (3).

2. Dispositif selon la revendication 1, **caractérisé en ce que** les moyens de répartition du gaz de refroidissement (36) comprennent au moins une paire de déflecteurs (42, 42') associée à au moins une paire d'orifices (44, 46) prévus dans le capot (4) de part et d'autre de la cloison séparatrice (30), au moins un déflecteur (42, 42') débouchant dans l'espace secondaire aval (40) et au moins un déflecteur (42, 42') débouchant dans l'espace secondaire amont (38).

3. Dispositif selon la revendication 1 ou 2, **caractérisé en ce que** les déflecteurs (42, 42') sont répartis de manière symétrique par rapport à la cloison séparatrice (30).

4. Dispositif selon l'une quelconque des revendications précédentes, **caractérisé en ce que** le déflecteur (42, 42') comprend une zone biseautée (52) à épaisseur croissante avec un bord (54) sensiblement confondu avec le surcapot (32) et un autre bord (56) sensiblement confondu avec le capot (4).

5. Dispositif selon la revendication 4, **caractérisé en ce que** le bord (54) sensiblement confondu avec le capot (4) de la zone biseautée (52) du déflecteur (42, 42') forme un bord d'attaque pour un déflecteur (42) situé dans l'espace secondaire amont (38) et un bord de fuite pour un déflecteur (42) situé dans l'espace secondaire aval (40).

6. Dispositif selon la revendication 4 ou 5, **caractérisé en ce que** le bord (56) sensiblement confondu avec le surcapot (32) de la zone biseautée (52) du déflecteur (42, 42') forme un bord de fuite pour un déflecteur (42, 42') situé dans l'espace secondaire amont (38) et un bord d'attaque pour un déflecteur (42, 42') situé dans l'espace secondaire aval (40).

7. Dispositif selon l'une quelconque des revendications 2 à 6, **caractérisé en ce que** chaque déflecteur (42, 42') comprend une zone centrale (48), sensiblement quadrangulaire, et une zone triangulaire (50) formant une extrémité en pointe, la hauteur de chacune des zones centrale (48) et triangulaire (50) étant égale à la distance entre le capot (4) et le surcapot (32).

8. Dispositif selon l'une quelconque des revendications 2 à 7, **caractérisé en ce que** chaque déflecteur (42, 42') est réalisé en un matériau ininflammable, par exemple du type polymère.

9. Dispositif selon l'une quelconque des revendications 2 à 7, **caractérisé en ce que** chaque déflecteur (42, 42') est réalisé en un matériau électriquement conducteur, par exemple du type métallique, ou polymère chargé et/ou revêtu.

10. Procédé de refroidissement de deux zones distinctes (A, B) d'un dispositif (1) à composants électroniques intégrés (2) qui comporte une carte (3) formant support pour lesdits composants (2), un capot (4) monté sur ladite carte (3) pour recouvrir lesdits composants (2), ainsi qu'une cloison (30) séparatrice qui s'étend du capot (4) à la carte (3) sensiblement perpendiculairement à celle-ci, ladite cloison (30) séparant lesdites deux zones distinctes (A, B) de la carte (3) dans lesquelles sont disposés lesdits composants électroniques (2), du gaz de refroidissement étant apte à être injecté dans une des deux zones distinctes (A, B) de la carte dite « zone amont » (B), et apte à être évacué dans l'autre des deux zones distinctes (A, B) de la carte, dite « zone aval» (A), **caractérisé en ce qu'**il comprend une étape de passage de gaz de refroidissement par des moyens de répartition de gaz (36) prévus dans un espace interne (34) entre le capot (4) et un surcapot (32) délimitant deux espaces secondaires (38, 40) distincts dans l'espace interne (34), un espace secondaire amont (38) dans lequel du gaz de refroidissement est injecté et un espace secondaire aval (40) dans lequel du gaz de refroidissement est évacué de manière telle que du gaz de refroidissement injecté dans la zone amont (B) de la carte (3) soit dirigé vers l'espace secondaire aval (40) de l'espace interne (34) et que du gaz de refroidissement injecté dans l'espace secondaire amont (38) de l'espace interne (34) soit dirigé vers la zone aval (A) de la carte (3).

## Claims

1. Device (1) with integrated electronic components (2), that comprises a board (3) forming a support for said components (2), a cover (4) mounted on said board (3) to cover said components (2), and a separating partition (30) which extends from the cover (4) to the board (3) substantially perpendicularly thereto, said partition (30) separating two distinct zones (A, B) of the board (3) in which electronic components (2) are located, cooling gas being able to be injected into one of the two distinct zones (A, B) of the board which is named "upstream zone" (B), and able to be discharged into the other of the two distinct zones (A, B) of the board, named "downstream zone" (A), **characterized in that** it comprises an overcover (32) covering the cover (4) and defining an internal space between the cover (4) and the overcover (32) in which cooling gas division means (36) are provided and define two distinct secondary spaces (38, 40) in the internal space (34), an upstream secondary space (38) into which cooling gas is able to be injected and a downstream secondary space (40) into which cooling gas is able to be discharged so that cooling gas injected into the upstream zone (B) of the board (3) is directed toward the downstream secondary space (40) of the internal space (34) and that cooling gas injected into the upstream secondary space (38) of the internal space (34) is directed toward the downstream zone (A) of the board (3).

2. Device according to Claim 1, **characterized in that** the cooling gas division means (36) comprise at least one pair of deflectors (42, 42') associated with at least one pair of orifices (44, 46) provided in the cover (4) on either side of the separating partition (30), at least one deflector (42, 42') opening into the downstream secondary space (40) and at least one deflector (42, 42') opening into the upstream secondary space (38).

3. Device according to Claim 1 or 2, **characterized in that** the deflectors (42, 42') are distributed in a symmetrical manner relative to the separating partition (30).

4. Device according to any one of the preceding claims, **characterized in that** the deflector (42, 42') comprises a beveled zone (52) with an increasing thickness with an edge (56) that is substantially mingling with the overcover (32) and another edge (54) substantially mingling with the cover (4).

5. Device according to Claim 4, **characterized in that** the edge (54) that is substantially mingling with the cover (4) of the beveled zone (52) of the deflector (42, 42') forms a leading edge for a deflector (42) situated in the upstream secondary space (38) and a trailing edge for a deflector (42) situated in the downstream secondary space (40).

6. Device according to Claim 4 or 5, **characterized in that** the edge (56) that is substantially mingling with the overcover (32) of the beveled zone (52) of the deflector (42, 42') forms a trailing edge for a deflector (42, 42') situated in the upstream secondary space (38) and a leading edge for a deflector (42, 42') situated in the downstream secondary space (40).

7. Device according to any one of Claims 2 to 6, **characterized in that** each deflector (42, 42') comprises a substantially quadrangular central zone (48), and a triangular zone (50) forming a pointed end, the height of each of the central zone (48) and the triangular zone (50) being equal to the distance between the cover (4) and the overcover (32).

8. Device according to any one of Claims 2 to 7, **characterized in that** each deflector (42, 42') is made of a nonflammable material, for example of the polymer type.

9. Device according to any one of Claims 2 to 7, **characterized in that** each deflector (42, 42') is made of an electrically conductive material, for example of the metal or filled and/or coated polymer type.

10. Method for cooling two distinct zones (A, B) of a device (1) with integrated electronic components (2) that comprises a board (3) forming a support for said components (2), a cover (4) mounted on said board (3) to cover said components (2), and a separating partition (30) which extends from the cover (4) to the board (3) substantially perpendicularly thereto, said partition (30) separating said two distinct zones (A, B) of the board (3) in which said electronic components (2) are located, cooling gas being able to be injected into one of the two distinct zones (A, B) of the board named "upstream zone" (B), and able to be discharged into the other of the two distinct zones (A, B) of the board, named "downstream zone" (A), **characterized in that** it comprises a step of passing cooling gas via gas division means (36) provided in an internal space (34) between the cover (4) and an overcover (32) delimiting two distinct secondary spaces (38, 40) in the internal space (34), an upstream secondary space (38) into which cooling gas is injected and a downstream secondary space (40) into which cooling gas is discharged so that cooling gas injected into the upstream zone (B) of the board (3) is directed toward the downstream secondary space (40) of the internal space (34) and that cooling gas injected into the upstream secondary space (38) of the internal space (34) is directed toward the downstream zone (A) of the board (3).

## Patentansprüche

1. Vorrichtung (1) mit integrierten elektronischen Bauteilen (2), die eine Karte (3), die einen Träger für die Bauteile (2) bildet, eine auf die Karte (3) montierte Abdeckung (4), um die Bauteile (2) zu bedecken, sowie eine Trennwand (30) aufweist, die sich von der Abdeckung (4) bis zur Karte (3) im Wesentlichen lotrecht zu dieser erstreckt, wobei die Trennwand (30) zwei unterschiedliche Zonen (A, B) der Karte (3) trennt, in denen elektronische Bauteile (2) angeordnet sind, wobei Kühlgas in eine der unterschiedlichen Zonen (A, B) der Karte, "vordere Zone" (B) genannt, injiziert und in der anderen der zwei unterschiedlichen Zonen (A, B) der Karte, "hintere Zone" (A) genannt, abgeführt werden kann, **dadurch gekennzeichnet, dass** sie eine Überabdeckung (32), die die Abdeckung (4) bedeckt und einen Innenraum zwischen der Abdeckung (4) und der Überabdeckung (32) definiert, in dem Einrichtungen zur Verteilung von Kühlgas (36) vorgesehen sind, die zwei unterschiedliche Sekundärräume (38, 40) im Innenraum (34) begrenzen, einen vorderen Sekundärraum (38), in den Kühlgas injiziert werden kann, und einen hinteren Sekundärraum (40) enthält, in dem Kühlgas abgeführt werden kann, derart, dass in die vordere Zone (B) der Karte (3) injiziertes Kühlgas zum hinteren Sekundärraum (40) des Innenraums (34) geleitet wird und dass in den vorderen Sekundärraum (38) des Innenraums (34) injiziertes Kühlgas zur hinteren Zone (A) der Karte (3) geleitet wird.

2. Vorrichtung nach Anspruch 1, **dadurch gekennzeichnet, dass** die Einrichtungen zur Verteilung des Kühlgases (36) mindestens ein Paar von Ablenkblechen (42, 42') aufweisen, die mindestens einem Paar von Öffnungen (44, 46) zugeordnet sind, die in der Abdeckung (4) zu beiden Seiten der Trennwand (30) vorgesehen sind, wobei mindestens ein Ablenkblech (42, 42') in den hinteren Sekundärraum (40) und mindestens ein Ablenkblech (42, 42') in den vorderen Sekundärraum (38) mündet.

3. Vorrichtung nach Anspruch 1 oder 2, **dadurch gekennzeichnet, dass** die Ablenkbleche (42, 42') symmetrisch bezüglich der Trennwand (30) verteilt sind.

4. Vorrichtung nach einem der vorhergehenden Ansprüche, **dadurch gekennzeichnet, dass** das Ablenkblech (42, 42') eine abgeschrägte Zone (52) mit zunehmender Dicke mit einem Rand (54), der im Wesentlichen mit der Überabdeckung (32) zusammenfällt, und einem anderen Rand (56), der im Wesentlichen mit der Abdeckung (4) zusammenfällt, aufweist.

5. Vorrichtung nach Anspruch 4, **dadurch gekennzeichnet, dass** der Rand (54) der abgeschrägten Zone (52) des Ablenkblechs (42, 42'), der im Wesentlichen mit der Abdeckung (4) zusammenfällt, eine Vorderkante für ein Ablenkblech (42), das sich im vorderen Sekundärraum (38) befindet, und eine Hinterkante für ein Ablenkblech (42) bildet, das sich im hinteren Sekundärraum (40) befindet.

6. Vorrichtung nach Anspruch 4 oder 5, **dadurch gekennzeichnet, dass** der Rand (56) der abgeschrägten Zone (52) des Ablenkblechs (42, 42'), der im Wesentlichen mit der Überabdeckung (32) zusammenfällt, eine Hinterkante für ein Ablenkblech (42, 42'), das sich im vorderen Sekundärraum (38) befindet, und eine Vorderkante für ein Ablenkblech (42, 42') bildet, das sich im hinteren Sekundärraum (40) befindet.

7. Vorrichtung nach einem der Ansprüche 2 bis 6, **dadurch gekennzeichnet, dass** jedes Ablenkblech (42, 42') eine im Wesentlichen viereckige zentrale Zone (48) und eine dreieckige Zone (50) aufweist, die ein spitzes Ende bildet, wobei die Höhe jeder der zentralen (48) und dreieckigen Zone (50) gleich dem Abstand zwischen der Abdeckung (4) und der Überabdeckung (32) ist.

8. Vorrichtung nach einem der Ansprüche 2 bis 7, **dadurch gekennzeichnet, dass** jedes Ablenkblech (42, 42') aus einem nicht brennbaren Werkstoff hergestellt ist, zum Beispiel vom Typ Polymer.

9. Vorrichtung nach einem der Ansprüche 2 bis 7, **dadurch gekennzeichnet, dass** jedes Ablenkblech (42, 42') aus einem elektrisch leitenden Werkstoff hergestellt ist, zum Beispiel vom Typ Metall oder angereichertes und/oder beschichtetes Polymer.

10. Verfahren zum Kühlen von zwei unterschiedlichen Zonen (A, B) einer Vorrichtung (1) mit integrierten elektronischen Bauteilen (2), die eine Karte (3), die einen Träger für die Bauteile (2) bildet, eine auf die Karte (3) montierte Abdeckung (4), um die Bauteile (2) zu bedecken, sowie eine Trennwand (30) aufweist, die sich von der Abdeckung (4) bis zur Karte (3) im Wesentlichen lotrecht zu dieser erstreckt, wobei die Trennwand (30) die zwei unterschiedlichen Zonen (A, B) der Karte (3) trennt, in denen die elektronischen Bauteile (2) angeordnet sind, wobei Kühlgas in eine der zwei unterschiedlichen Zonen (A, B) der Karte, "vordere Zone" (B) genannt, injiziert und in der anderen der zwei unterschiedlichen Zonen (A, B) der Karte, "hintere Zone" (A) genannt, abgeführt werden kann, **dadurch gekennzeichnet, dass** es einen Schritt des Durchgangs von Kühlgas durch in einem Innenraum (34) zwischen der Abdeckung (4) und einer Überabdeckung (32) vorgesehene Einrichtungen zur Verteilung des Gases 36) enthält, die zwei unterschiedliche Sekundärräume (38, 40) im Innenraum (34) definieren, einen vorderen Sekundärraum (38), in den Kühlgas injiziert wird, und einen hinteren Sekundärraum (40), in dem Kühlgas derart abgeführt wird, dass in die vordere Zone (B) der Karte (3) injiziertes Kühlgas zum hinteren Sekundärraum (40) des Innenraums (34) geleitet wird, und dass in den vorderen Sekundärraum (38) des Innenraums (34) injiziertes Kühlgas zur hinteren Zone (A) der Karte (3) geleitet wird.
